# EUROPÄISCHE PATENTSCHRIFT

(11) **EP 1 095 453 B1**
(45) Veröffentlichungstag und Bekanntmachung des Hinweises auf die Patenterteilung: **28.04.2010**
(21) Anmeldenummer: 99945866.4
(22) Anmeldetag: 01.07.1999
(51) Int. Cl.: H03K 17/16

(54) **SCHALTUNGSANORDNUNG ZUM ANSTEUERN EINER SCHALTVORRICHTUNG ZUM SCHALTEN EINES ELEKTRISCHEN VERBRAUCHERS**
CIRCUIT FOR CONTROLLING A SWITCHING DEVICE FOR SWITCHING AN ELECTRIC CONSUMER
CIRCUIT PERMETTANT DE COMMANDER UN DISPOSITIF DE COMMUTATION AFIN DE COMMUTER UN APPAREIL ELECTRIQUE

(30) Priorität: 03.07.1998 DE 19829837
(43) Veröffentlichungstag der Anmeldung: 02.05.2001
(73) Patentinhaber: Infineon Technologies AG, 85579 Neubiberg (DE)
(72) Erfinder: FELDTKELLER, Martin, D-81543 München (DE)
(74) Vertreter: Bickel, Michael
(86) Internationale Anmeldenummer: PCT/DE1999/002010
(87) Internationale Veröffentlichungsnummer: WO 2000/002312

(56) Entgegenhaltungen:
- DE-A- 4 303 905
- US-A- 4 473 790
- US-A- 5 287 046
- US-A- 5 729 153

## Beschreibung

Die Erfindung betrifft eine Schaltungsanordnung zum Schalten eines elektrischen Verbrauchers, insbesondere eines induktiven Verbrauchers. Insbesondere betrifft die Erfindung eine Steuervorrichtung zum Schalten von Elektromotoren höherer Leistungen, insbesondere mehrphasiger Antriebe wie Drehstrommotoren, beispielsweise zur Verwendung im Automobilbau.

Derartige Antriebe werden bei einer üblichen Versorgungsspannung von 12 Volt oder 14 Volt mit einer hohen Frequenz von beispielsweise 20 kHz bei Strömen von 100 Ampere oder mehr getaktet. Unter diesen Bedingungen dominieren Schaltverluste die Gesamtverluste der Hochleistungs-Halbleiter-Schaltelemente der Steuervorrichtung. Diese Schaltverluste hängen von der Dauer des Schaltvorganges ab. Daher muß ein Schaltvorgang so schnell wie möglich ablaufen. Dabei soll und darf die Spannungs-Flankensteilheit dU/dt der Schaltflanken relativ hoch sein, weil die kapazitive Abstrahlung der Zuleitungen zu der Steuerelektronik zum elektrischen Verbraucher eine untergeordnete Rolle spielt. Andererseits beeinflussen Streuinduktivitäten die Schaltvorgänge derart, daß eine möglichst genaue Begrenzung der Stromanstiegsrate bzw. Stromabfallrate dI/dt des Schaltstroms unbedingt erforderlich ist.

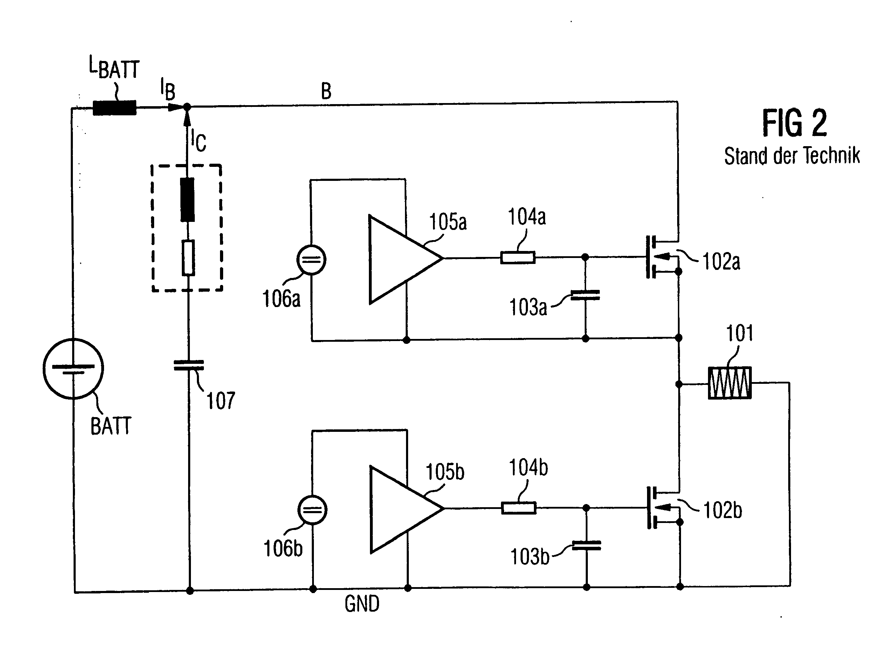

Aus der deutschen Patentanmeldung DE 4 330 996 A1 ist eine Steuereinrichtung für einen elektrischen, insbesondere einen induktiven Verbraucher bekannt, bei der Kondensatoren parallel zwischen dem Gate- und dem Source-Anschluß der Leistungs-MOS-Transistoren geschaltet sind, um die zeitliche Stromänderung dI/dt und die zeitliche Spannungsänderung dU/dt weitgehend unabhängig voneinander einstellen zu können. Eine derartige Steuervorrichtung ist schematisch in dem Schaltbild von Fig. 2 dargestellt. Der Verbraucher 101 wird durch die Feldeffekttransistoren 102a, 102b angesteuert, deren Gate-Anschlüsse über Widerstände 104a, 104b mit Treiberschaltungen 105a, 105b verbunden sind. Die Feldeffekttransistoren 102a, 102b sind seriell miteinander verschalten und bilden eine Halbbrücke, mit deren Mittelabgriff der Verbraucher 101 verbunden ist. Zwischen Gate-Kontakt und Source-Kontakt der Transistoren 102a, 102b sind jeweils Kondensatoren 103a, 103b verbunden. Bei dieser bekannten Steuervorrichtung tritt das Problem auf, daß die Zeit bis zum Erreichen des minimalen Einschaltwiderstandes sich ebenfalls erheblich verlängert und daß wesentlich größere Treiberleistungen erforderlich sind. Die bekannte Vorrichtung ist daher vorzugsweise für Lastströme unterhalb 10 Ampere einsetzbar. Ein weiteres Problem liegt darin, daß Schaltungsanordnungen, die zu Gate-Source-Abschnitten von Leistungstransistoren parallel geschaltete Kondensatoren enthalten, zu Schwingungen neigen.

Der vorliegenden Erfindung liegt daher die Aufgabe zugrunde, eine Schaltungsanordnung zum Ansteuern einer Schaltvorrichtung zum Schalten eines elektrischen Verbrauchers vorzuschlagen, bei der die Schaltverluste minimiert werden können und die zeitliche Änderung des Schaltstroms dI/dt auf einen Maximalwert eingestellt werden kann. Die Vorrichtung soll auch für sehr große Ströme in der Größenordnung von 100 Ampere oder mehr einsetzbar sein und einen einfachen Aufbau aufweisen.

Gelöst wird die Aufgabe durch die in Anspruch 1 definierte Steuervorrichtung sowie das in Anspruch 13 definierte Verfahren. Vorteilhafte Weiterbildungen der erfindungsgemäßen Steuervorrichtung sind in den Unteransprüchen beschrieben.

Die erfindungsgemäße Schaltungsanordnung weist eine Spannungsquelle mit einem hohen und einen niederen Versorgungspotential auf, wobei die Schaltvorrichtung über eine Zuleitung mit dem hohen Versorungspotential verbunden ist. Ferner ist eine Treiberschaltung zum Ansteuerung der Schaltvorrichtung vorgesehen. Sie beinhaltet eine Einrichtung zum Erfassen der Amplitude von an der Zuleitung auftretenden Spannungsspitzen. Die Schaltungsanordnung weist weiterhin eine Rückkoppelschaltung zur Rückkoppelsteuerung der Treiberschaltung in Abhängigkeit von der durch die Erfassungseinrichtung erfaßten Induktionsspannung auf, wobei die zeitliche Änderung des Schaltstromes dI/dt auf einen festgelegten Maximalwert begrenzt ist.

Schnelle Schaltvorgänge verursachen an allen Induktivitäten in Serie mit dem Leistungsschalter Spannungsspitzen. Diese werden durch die Erfassungseinrichtung erfaßt und die Schaltstromänderung entsprechend nachgeregelt. Die Schaltung paßt sich damit automatisch an ihre Umgebung, beispielsweise an aufbaubedingte Streuinduktivitäten an. Außerdem wird die Flankensteilheit dU/dt der Versorgungsspannung des Verbrauchers nicht beeinflußt. Des weiteren benötigt die erfindungsgemäße Steuerschaltung weniger externe Schaltelemente als die eingangs erwähnte bekannte Steuervorrichtung.

Vorzugsweise weist die Schaltvorrichtung zwei zu einer Halbbrücke verschaltete Feldeffekttransistoren auf, deren Gate-Kontakte jeweils mit dem Ausgang einer Treiberschaltung verbunden sind. Die Rückkoppelschaltung steuert diese Treiberschaltungen vorzugsweise so an, daß eine von der Erfassungseinrichtung erfaßte betragsmäßig kleine Spannung einen großen Gate-Strom der Feldeffekttransistoren und damit eine große Schaltstromänderung dI/dt hervorruft und eine von der Erfassungseinrichtung erfaßte betragsmäßig große Spannung einen kleinen Gate-Strom der Feldeffekttransistoren und damit eine kleine Schaltstromänderung dI/dt hervorruft. Die Stromsteuerung über die Treiberschaltungen beeinflußt so die Flankensteilheit dU/dt der Spannungen an den Feldeffekttransistoren nicht.

Vorzugsweise- weist die Schaltungsanordnung einen parallel zur Spannungsquelle des Verbrauchers geschalteten Abblockkondensator auf. Die Erfassungseinrichtung weist vorzugsweise eine parallel zu dieser Spannungsquelle geschaltete Reihenschaltung eines Kondensators mit einem Ohm' schen Widerstand auf. Der Kondensator ist dabei mit einem Anschluß mit dem hohen Versorungspotential verbunden. Für eine bestmögliche Funktion der Schaltung entspricht die kapazitive Zeitkonstante C_{F} R_{F} der Erfassungseinrichtung ungefähr der induktiven Zeitkonstante L_{E}/R_{E} der Zuleitungen des Abblockkondensators.

Die Erfassungseinrichtung kann als Steuergröße die Amplitude von an der Zuleitung des Abblockkondensators oder an den Versorgungsklemmen der Spannungsquelle auftretende Spannungsspitzen erfassen und als Steuergröße der Rückkoppelschaltung zuführen. Die Schaltung paßt sich somit automatisch an ihre Umgebung an, insbesondere an die Serieninduktivität des Abblockkondensators.

Für mehrere Treiberschaltungen und Feldeffekttransistoren kann eine gemeinsame Erfassungseinrichtung und eine gemeinsame Rückkoppelschaltung vorgesehen sein, da gleichzeitig schaltende Transistoren auch gemeinsam für eine Spannungsspitze verantwortlich sind und nicht schaltende Transistoren durch den Eingriff der Rückkoppelschaltung nicht beeinflußt werden.

Vorzugsweise ist die maximale zeitliche Schaltstromänderung dI/dt auf einem noch tolerierbaren Wert einstellbar.

Im folgenden wird die Erfindung anhand eines bevorzugten Ausführungsbeispiels unter Bezugnahme auf die beiliegende Zeichnung näher erläutert, in der
Fig. 1 ein Schaltbild eines Ausführungsbeispiels der erfindungsgemäßen-Schaltungsanordnung ist; und
Fig. 2 ein Schaltbild einer bekannten Schaltungsanordnung zum Schalten eines elektrischen Verbrauchers ist.

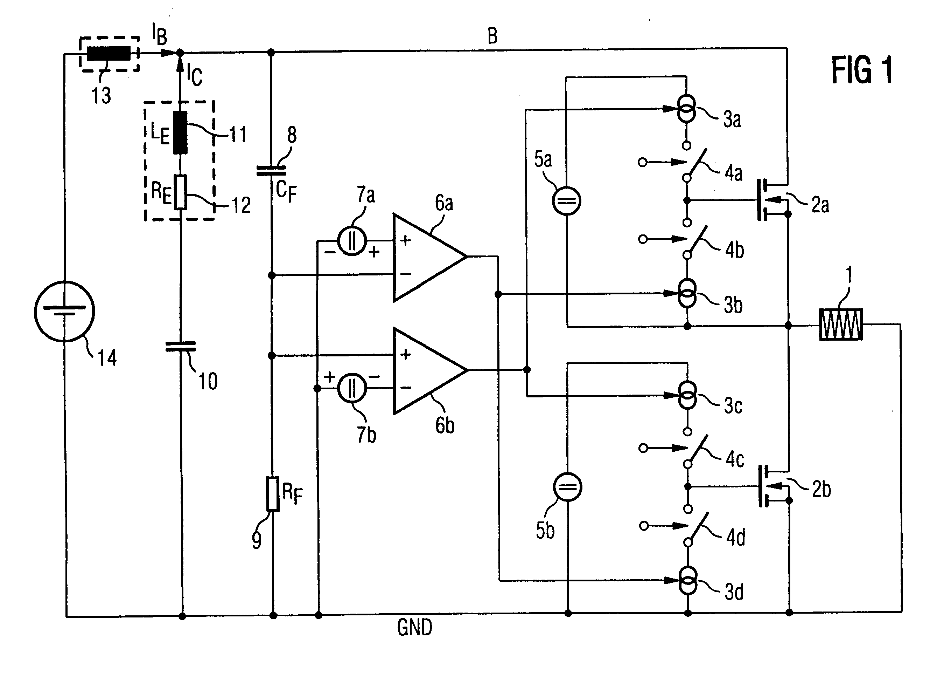

Fig. 1 zeigt ein bevorzugtes Ausführungsbeispiel der erfindungsgemäßen Schaltungsanordnung zum Schalten eines elektrischen Verbrauchers. Eine Spannungsquelle 14 wie etwa eine Kraftfahrzeugbatterie liefert eine Gleichspannung von beispielsweise ungefähr 14 Volt. Mit 13 ist eine Zuleitungsinduktivität der Zuleitung von der Stromquelle 14 zu den Leistungs-Schaltelementen 2a, 2b bezeichnet. Letztere sind vorzugsweise als Leistungs-MOS-Transistoren ausgebildet. Am Drain-Kontakt des Schaltelements 2a liegt die Klemmenspannung B und am Source-Anschluß des Schaltelements 2b Masse GND an. Die Schaltelemente 2a, 2b bilden zusammen eine Halbbrücke, die mit dem Verbraucher 1 in bekannter Weise verschaltet ist. Die Leistungstransistoren 2a, 2b werden über mit den Gate-Anschlüssen verbundene Treiberschaltungen angesteuert, die Spannungsquellen 5a, 5b, gesteuerte Stromquellen 3a, 3b bzw. 3c, 3d und Schaltelemente 4a, 4b bzw. 4c, 4d aufweisen, die wiederum mittels geeigneter Steuersignale angesteuert werden.

Schnelle Schaltvorgänge verursachen an allen Induktivitäten in Serie mit dem Leistungsschalter Spannungsspitzen. Die Zuleitungsinduktivität 13 von der Spannungsquelle 14 zu den Leistungs-Schaltelementen 2a, 2b beträgt ungefähr 5µH. über sie kann nur der mittlere Gleichstromanteil Indes Versorgungsstromes fließen. Wechselstromanteile müssen durch Abblockkondensatoren aufgefangen werden. In dem in Fig. 1 dargestellten Ausführungsbeispiel ist exemplarisch ein Abblockkondensator 10 dargestellt, der einschließlich Zuleitung konstruktionsbedingt eine Ersatz-Induktivität L_{E} (11) und einen Ohm' schen Ersatz-Widerstand R_{E} (12) aufweist. Die Induktivität L_{E} liegt dabei in der Größenordnung von 5 nH bis 50 nH, durch die an den Versorgungsklemmen bei Schaltvorgängen weiterhin Spannungsspitzen entstehen können. Damit diese nicht beliebig hoch werden, ist eine Begrenzung der zeitlichen Stromänderung dI/dt erforderlich. Auf den Abblockkondensator kann auch verzichtet werden, wenn die Zuleitung zwischen der Spannungsquelle 14 und der Schaltungsvorrichtung kurz ist. In diesem Fall übernimmt die Spannungsquelle die Funktion des Abblockkondensators.

Eine Erfassungsschaltung aufweisend einen Kondensator 8 mit Kapazität C_{F} und einen Ohm'schen Widerstand R_{F}, die in Serie zwischen die Versorgungsklemmen der Spannungsquelle geschaltet sind, erfaßt über die Wechselstrom-Ankopplung mittels des Kondensators 8 an die Versorgungsspannung B durch Schaltvorgänge induzierte Spannungsspitzen. Eine Spannungsänderung an der parasitären Serieninduktivität 11 des Abblockkondensators 10 oder am Ersatz-Serienwiderstand 12 führt damit auch zu einer Spannungsänderung am Ausgang der Erfassungsschaltung, die als Steuergröße der Rückkoppelschaltung 6, 7 zugeführt wird. Das Vorsehen des Widerstandes R_{F} ermöglicht es, der Rückkoppelschaltung 6, 7 den Absolutwert der durch Induktion hervorgerufenen Spannungsänderung zuzuführen. Die Rückkoppelschaltung wird durch Differenzenverstärker 6a, 6b gebildet, deren Ausgänge mit jeweils einer gesteuerten Stromquelle 3a bis 3d der Treiberschaltung für die Leistungstransistoren 2a, 2b verbunden sind. Der nicht-invertierende Eingang des ersten Differenzenverstärkers 6a ist mit dem positiven Anschluß einer Spannungsquelle 7a und der invertierende Eingang des Differenzenverstärkers 6b mit dem negativen Anschluß der Spannungsquelle 7b verbunden. Der invertierende Anschluß des ersten Differenzenverstärkers 6a und der nicht-invertierende Anschluß des zweiten Differenzenverstärkers 6b sind mit dem Ausgang der Erfassungsschaltung, d.h. dem Verbindungspunkt des Kondensators 8 mit dem Widerstand 9 verbunden.

Die Funktionsweise der in Fig. 1 dargestellten erfindungsgemäßen Steuervorrichtung wird im folgenden kurz erläutert.

Die Erfassungseinrichtung 8, 9 erfaßt über die kapazitive Ankopplung mittels Kondensator 8 an der Induktivität 13 oder der Induktivität 11 auftretende Induktionsspannungen, die von schnellen Stromänderungen des Schaltstroms hervorgerufen werden. Die Erfassungseinrichtung 8, 9 erfaßt somit direkt die zu begrenzende Störgröße, nämlich durch den Schaltvorgang erzeugte unerwünschte Spannungsspitzen. Die Schaltung paßt sich damit automatisch an ihre Umgebung an, insbesondere an die Serieninduktivität des Abblockkondensators 10 oder an aufbaubedingte Streuinduktivitäten. Die so erfaßte Steuergröße wird über die Rückkoppelschaltung 6, 7 den Treibern 3, 4, 5 zugeführt, die die Leistungstransistoren 2a, 2b so steuern, daß eine von der Erfassungseinrichtung erfaßte betragsmäßig kleine Spannung einen großen Gate-Strom der Feldeffekttransistoren und damit eine große Source-Drain-Stromänderung dI/dt hervorruft und umgekehrt eine von der Erfassungseinrichtung erfaßte betragsmäßig große Spannung einen kleinen Gate-Strom und damit eine kleine Änderung des Drain-Source-Stromes dI/dt an den Leistungstransistoren hervorruft. Werden also zu hohe induktive Spannungsspitzen erfaßt, wird die Stromzufuhr zu den Gates der Leistungstransistoren gedrosselt, wodurch sich die Stromsteilheit der Leistungstransistoren unabhängig von der Spannungssteilheit verringert.

Für eine bestmögliche Funktion der erfindungsgemäßen Schaltung sollte die kapazitive Zeitkonstante T_{F} = C_{F} · R_{F} der Erfassungseinrichtung 8, 9 etwa gleich der induktiven Zeitkonstante T_{E} = L_{E}/R_{E} des Abblockkondensators 10 sein.

Wird die erfindungsgemäße Steuervorrichtung für einen mehrphasigen Halbbrückentreiber verwendet, so genügt eine Erfassungseinrichtung und eine Rückkoppelschaltung für alle Halbbrücken gemeinsam, sofern sie einen gemeinsamen Abblockkondensator besitzen oder mehrere Abblockkondensatoren gemeinsam benutzen.

Die erfindungsgemäße Schaltungsanordnung zum Schalten eines elektrischen Verbrauchers und das erfindungsgemäße Verfahren zur Begrenzung der zeitlichen Änderung des Stromes eines Verbrauchers ermöglicht so eine verlustarme, hochfrequente Leistungs-Ansteuerung eines Verbrauchers wie eines Drehstrommotors, wobei die auftretenden Stromänderungen dI/dt und dadurch verursachten Induktionsspannungsspitzen auf einen festgelegten Maximalwert begrenzt werden können.

## Patentansprüche

1. Schaltungsanordnung zum Schalten eines elektrischen Verbrauchers (1) mittels einer Schaltvorrichtung (2a, 2b)
mit einer Spannungsquelle (14) mit zwei Ausgangsklemmen, an denen ein hohes und ein niedriges Versorungspotential (B, GND) abgreifbar ist,
mit einer Treiberschaltung (3a bis 3d, 4a bis 4d, 5a, 5b) zum Treiben der Schaltvorrichtung (2, 2b), die zwei Eingangsklemmen aufweist, über die sie mit der Schaltvorrichtung (2a, 2b) verbunden ist,
mit einer Zuleitung, die zwischen den Ausgangsklemmen der Spannungsquelle (14) und den Eingangsklemmen der Treiberschaltung angeordnet ist und die eine Zuleitungsinduktivität (13) aufweist,
mit einer Mess- und Auswerteschaltung (8, 9) zum Erfassen von durch Stromänderungen (DI_{B/}DT) in der Zuleitungsinduktivität (13) sich ergebenden Spannungsspitzen an den Eingangsklemmen der Treiberschaltung, und zum Auswerten der Stromänderungen,
mit einer Rückkoppelschaltung (6a, 6b, 7a, 7b) zur Rückkopplungssteuerung der Treiberschaltung, in Abhängigkeit von den Spannungsspitzen derart, dass eine zeitliche Änderung eines den Verbraucher durchfließenden Schaltstromes reduziert wird, wenn die Spannungsspitzen einen Schwellenwert übersteigen.

2. Schaltungsanordnung nach Anspruch 1,
**dadurch gekennzeichnet,**
**daß** die Schaltungsvorrichtung (2a, 2b) zwei in Form einer Halbbrücke verschaltene Feldeffekttransistoren (2a, 2b) aufweist, deren Gate-Kontakte jeweils mit dem Ausgang einer Treiberschaltung (3, 4, 5) verbunden sind.

3. Schaltungsanordnung nach Anspruch 2,
**dadurch gekennzeichnet,**
**daß** der Drain-Anschluß eines ersten Feldeffekttransistors (2a) mit dem hohen Versorgungspotential (B) und der Source-Anschluß eines zweiten Feldeffekttransistors (2b) mit einem Bezugspotential (GND) verbunden ist.

4. Schaltungsanordnung nach Anspruch 2 oder 3,
**dadurch gekennzeichnet,**
**daß** die Rückkoppelschaltung (6, 7) die Treiberschaltung (3, 4, 5) so ansteuert, daß eine von der Erfassungseinrichtung (8, 9) erfaßte betragsmäßig kleine Spannung einen großen Gate-Strom der Feldeffekttransistoren (2a, 2b) und damit eine große Schaltstromänderung dI/dt hervorruft und umgekehrt eine⁻ von der Erfassungseinrichtung (8, 9) erfaßte betragsmäßig große Spannung einen kleinen Gate-Strom der Feldeffekttransistoren (2a, 2b) und damit eine kleine Schaltstromänderung dI/dt hervorruft.

5. Schaltungsanordnung nach einem der Ansprüche 1 bis 4,
**dadurch gekennzeichnet,**
**daß** die Erfassungseinrichtung (8, 9) eine parallel zur Spannungsquelle (14) des Verbrauchers (1) geschaltete Reihenschaltung eines Kondensators (8) mit einem Ohm'schen Widerstand (9) aufweist.

6. Schaltungsanordnung nach einem der Ansprüche 1 bis 5, **gekennzeichnet durch** einen parallel zur Spannungsquelle (14) geschalteten Abblockkondensator (10).

7. Schaltungsanordnung nach Anspruch 5 und Anspruch 6,
**dadurch gekennzeichnet,**
**daß** die kapazitive Zeitkonstante T_{F} = C_{F} · R_{F} der Erfassungseinrichtung (8, 9) näherungsweise gleich der induktiven Zeitkonstante T_{E} = L_{E}/R_{E} des Abblockkondensators (10) ist, wobei
C_{F} = die Kapazität des Kondensators (8) der Erfassungseinrichtung (8, 9),
R_{F} = der Widerstand des Ohm'schen Widerstandes (9) der Erfassungseinrichtung (8, 9),
L_{E} = die Induktivität, und
R_{E} = der Ohm'sche Widerstand der Zuleitung zum Abblockkondensator (10) ist.

8. Schaltungsanordnung nach einem der Ansprüche 5 bis 7,
**dadurch gekennzeichnet,**
**daß** der Kondensator (8) mit dem hohen Versorgungspotential (B) verbunden ist.

9. Schaltungsanordnung nach einem der Ansprüche 1 bis 8,
**dadurch gekennzeichnet,**
**daß** die Erfassungseinrichtung (8, 9) die Amplitude von an den Versorgungsklemmen der Spannungsquelle (14) des Verbrauchers (1) auftretenden Spannungsspitzen erfaßt und der Rückkoppelschaltung (6, 7) als Steuergröße zuführt.

10. Schaltungsanordnung nach einem der Ansprüche 2 bis 9,
**dadurch gekennzeichnet,**
**daß** für mehrere Treiberschaltungen (3, 4, 5) und Feldeffekttransistoren (2a, 2b) eine gemeinsame Rückkoppelschaltung (6, 7) und Erfassungsschaltung (8,9) vorgesehen ist.

11. Schaltungsanordnung nach einem der Ansprüche 1 bis 10,
**dadurch gekennzeichnet,**
**daß** die maximale zeitliche Stromänderung dI/dt des Verbrauchers (1) einstellbar ist.

12. Schaltungsanordnung nach einem der Ansprüche 1 bis 11,
**dadurch gekennzeichnet,**
**daß** die Steuervorrichtung zum Schalten eines induktiven Verbrauchers (1) insbesondere eines Drehstrommotors ausgebildet ist.

13. Verfahren zur Begrenzung der zeitlichen Änderung dI/dt, des Schaltstromes eines Verbrauchers mittels einer Schaltungsanordnung nach einem der vorstehenden Ansprüche, aufweisend die Verfahrensschritte:
Erfassung des Betrags einer durch die Stromänderungen dI/dt hervorgerufenen Induktionsspannung an einer Zuleitung zwischen hohen Versorgungspotential (B) und einer Schaltvorrichtung;
Regelung der Spannungs- und/oder der Stromversorgung des - elektrischen Verbrauchers in Abhängigkeit von einer erfaßten Induktionsspannung derart, daß die zeitliche Stromänderung dI/dt auf einen festgelegten Maximalwert begrenzt wird.

## Claims

1. Circuit arrangement for switching an electrical load (1) by means of a switching apparatus (2a, 2b)
having a voltage source (14) with two output terminals, at which a high and a low supply potential (B, GND) can be tapped off,
having a driver circuit (3a to 3d, 4a to 4d, 5a, 5b) for driving the switching apparatus (2a, 2b), which has two input terminals via which it is connected to the switching apparatus (2a, 2b),
having a supply line, which is arranged between the output terminals of the voltage source (14) and the input terminals of the driver circuit and has a supply-line inductance (13),
having a measurement and evaluation circuit (8, 9) for detection of voltage spikes, which result from current changes (DI_{B}/DT) in the supply-line inductance (13), at the input terminals of the driver circuit, and for evaluation of the current changes,
having a feedback circuit (6a, 6b, 7a, 7b) for feedback control of the driver circuit as a function of the voltage spikes, such that the rate of change of a switching current flowing through the load is reduced when the voltage spikes exceed a threshold value.

2. Circuit arrangement according to Claim 1, **characterized in that** the switching apparatus (2a, 2b) has two field-effect transistors (2a, 2b), which are connected in the form of a half-bridge and whose gate contacts are each connected to the output of a driver circuit (3, 4, 5).

3. Circuit arrangement according to Claim 2, **characterized in that** the drain connection of a first field-effect transistor (2a) is connected to the high supply potential (B), and the source connection of a second field-effect transistor (2b) is connected to a reference ground potential (GND).

4. Circuit arrangement according to Claim 2 or 3, **characterized in that** the feedback circuit (6, 7) operates the driver circuit (3, 4, 5) such that a voltage with a low magnitude and which is detected by the detection device (8, 9) causes a high gate current in the field-effect transistors (2a, 2b), and therefore a high switching current change dI/dt and, conversely, a voltage with a high magnitude which is detected by the detection device (8, 9) causes a small gate current in the field-effect transistors (2a, 2b), and therefore a small switching current change dI/dt.

5. Circuit arrangement according to one of Claims 1 to 4, **characterized in that** the detection device (8, 9) has a series circuit of a capacitor (8) with an ohmic resistor (9) connected in parallel with the voltage source (14) of the load (1).

6. Circuit arrangement according to one of Claims 1 to 5, **characterized by** a blocking capacitor (10) connected in parallel with the voltage source (14).

7. Circuit arrangement according to Claim 5 and Claim 6, **characterized in that** the capacitive time constant T_{F} = C_{F} · R_{F} of the detection device (8, 9) is approximately equal to the inductive time constant T_{E} = L_{E/}R_{E} of the blocking capacitor (10), where
C_{F} = the capacitance of the capacitor (8) in the detection device (8, 9),
R_{F} = the resistance of the ohmic resistor (9) in the detection device (8, 9),
L_{E} = the inductance, and
R_{E} = the ohmic resistance of the supply line to the blocking capacitor (10) .

8. Circuit arrangement according to one of Claims 5 to 7, **characterized in that** the capacitor (8) is connected to the high supply potential (B).

9. Circuit arrangement according to one of Claims 1 to 8, **characterized in that** the detection device (8, 9) detects the amplitude of voltage spikes which occur at the supply terminals of the voltage source (14) of the load (1), and supplies them as a control variable to the feedback circuit (6, 7).

10. Circuit arrangement according to one of Claims 2 to 9, **characterized in that** a common feedback circuit (6, 7) and detection circuit (8, 9) are provided for a plurality of driver circuits (3, 4, 5) and field-effect transistors (2a, 2b) .

11. Circuit arrangement according to one of Claims 1 to 10, **characterized in that** the maximum rate of current change dI/dt of the load (1) is adjustable.

12. Circuit arrangement according to one of Claims 1 to 11, **characterized in that** the control apparatus is designed to switch an inductive load (1), in particular a polyphase motor.

13. Method for limiting the rate of change dI/dt of the switching current of a load by means of a circuit arrangement according to one of the preceding claims, having the following method steps:
detection of the magnitude of an induced voltage, caused by the current changes dI/dt, on a supply line between the high supply potential (B) and a switching apparatus;
regulation of the voltage and/or current supply of the electrical load as a function of a detected induced voltage, such that the rate of change of the current dI/dt is limited to a fixed maximum value.

## Revendications

1. Circuit de commutation d'un appareil (1) électrique au moyen d'un dispositif (2a, 2b) de commutation
comprenant une source (14) de tension ayant deux bornes de sortie sur lesquelles un potentiel (B, GND) d'alimentation haut et un potentiel d'alimentation bas peut être prélevé,
comprenant un circuit (3a à 3d, 4a à 4d, 5a, 5b) d'attaque, pour attaquer le dispositif (2, 2b) de commutation qui a deux bornes d'entrée par lesquelles il est relié au dispositif (2a, 2b) de commutation,
comprenant une ligne d'amenée qui est disposée entre les bornes de sortie de la source (14) de tension et les bornes d'entrée du circuit d'attaque et qui a une inductance (13) d'amenée,
comprenant un circuit (8, 9) de mesure et d'exploitation pour relever des pointes de tension sur des bornes d'entrée du circuit d'attaque se produisant par des variations (DI_{B}/DT) de courant dans l'inductance (13) d'amenée et pour exploiter les variations de courant,
comprenant un circuit (6a, 6b, 7a, 7b) de réaction pour la commande en réaction du circuit d'attaque en fonction des pointes de tension, de manière à réduire une variation dans le temps du courant de commutation passant dans l'appareil électrique lorsque les pointes de tension dépassent une valeur de seuil.

2. Circuit suivant la revendication 1,
**caractérisé**
**en ce que** le dispositif (2a, 2b) de commutation a deux transistors (2a, 2b) à effet de champ, qui sont montés en demi pont et dont les contacts de grille sont reliés respectivement à la sortie d'un circuit (3, 4, 5) d'attaque.

3. Circuit suivant la revendication 2,
**caractérisé**
**en ce que** la borne de drain d'un premier transistor (2a) à effet de champ est reliée au potentiel (B) haut d'alimentation et la borne de source d'un deuxième transistor (2b) à effet de champ est reliée à un potentiel (GND) de référence.

4. Circuit suivant la revendication 2 ou 3,
**caractérisé**
**en ce que** le circuit (6, 7) de réaction du circuit (3, 4, 5) d'attaque est commandé de manière à ce qu'une tension basse en valeur absolue, détectée par le dispositif (8, 9) de détection, provoque un courant de grille intense des transistors (2a, 2b) à effet de champ et ainsi une grande variation dI/dt du courant de commutation et inversement qu'une tension haute en valeur absolue, détectée par le dispositif (8, 9) de détection, provoque un courant de grille peu intense des transistors (2a, 2b) à effet de champ et ainsi une petite variation (dI/dt) du courant de commutation.

5. Circuit suivant l'une des revendications 1 à 4,
**caractérisé**
**en ce que** le dispositif (8, 9) de détection a un circuit série qui est composé d'un condensateur (8) et d'une résistance (9) ohmique et qui est monté en parallèle à la source (14) de tension de l'appareil (1) électrique.

6. Circuit suivant l'une des revendications 1 à 5,
**caractérisé**
**par** un condensateur (10) de blocage monté en parallèle à la source (14) de tension.

7. Circuit suivant la revendication 5 et la revendication 6,
**caractérisé**
**en ce que** la constante de temps capacitive T_{F} = C_{F} · R_{F} du dispositif (8, 9) de détection est à peu près égale à la constante de temps inductive T_{E} = L_{E}/R_{E} du condensateur (10) de blocage, avec
C_{F} = capacité du condensateur (8) du dispositif (8, 9) de détection,
R_{F} = valeur de la résistance (9) ohmique du dispositif (8, 9) de détection,
LE = inductance, et
R_{E} = résistance ohmique de la ligne d'amenée allant au condensateur (10) de blocage.

8. Circuit suivant l'une des revendications 5 à 7,
**caractérisé**
**en ce que** le condensateur (8) est relié au potentiel (B) haut d'alimentation.

9. Circuit suivant l'une des revendications 1 à 8,
**caractérisé**
**en ce que** le dispositif (8, 9) de détection détecte les amplitudes de pointes de tension se produisant sur les bornes d'alimentation de la source (14) de tension de l'appareil (1) électrique et les envoie en tant que grandeurs de commande au circuit (6, 7) de réaction.

10. Circuit suivant l'une des revendications 2 à 9,
**caractérisé**
**en ce qu'**il est prévu un circuit (6, 7) de réaction et un circuit (8, 9) de détection commun pour plusieurs circuits (3, 4, 5) d'attaque et transistors (2a, 2b) à effet de champ.

11. Circuit suivant l'une des revendications 1 à 10,
**caractérisé**
**en ce que** la variation dI/dt maximum de courant en fonction du temps de l'appareil (1) électrique est réglable.

12. Circuit suivant l'une des revendications 1 à 11,
**caractérisé**
**en ce que** le dispositif de commande est constitué pour la commutation d'un appareil (1) électrique inductif, notamment d'un moteur à courant triphasé.

13. Procédé de limitation de la variation dI/dt dans le temps du courant de commutation d'un appareil électrique, au moyen d'un circuit suivant l'une quelconque des revendications précédentes, comprenant les stades de procédé dans desquels :
on détecte la valeur absolue d'une tension d'induction provoquée par les variations dI/dt de courant sur une ligne d'amenée entre un potentiel (B) haut d'alimentation et un dispositif de commutation ;
on régule l'alimentation en tension et/ou l'alimentation en courant de l'appareil électrique en fonction d'une tension d'induction détectée de manière à limiter la variation dI/dt de courant en fonction du temps à une valeur maximum fixée.
